Europäisches Patentamt

European Patent Office

Office européen des brevets

(19)

(11) Publication number : **0 442 688 A2**

# (12) EUROPEAN PATENT APPLICATION

(21) Application number : **91301095.5**

(22) Date of filing : **12.02.91**

(51) Int. Cl.⁵ : **H03K 5/24, H03K 17/693**

(30) Priority : **13.02.90 JP 31862/90**

(43) Date of publication of application :
**21.08.91 Bulletin 91/34**

(84) Designated Contracting States :
**DE FR GB**

(71) Applicant : **SEIKO INSTRUMENTS INC.**
**31-1, Kameido 6-chome Koto-ku**
**Tokyo 136 (JP)**

(72) Inventor : **Shimoda, Sadashi**
**c/o SEIKO INSTRUMENTS INC., 31-1,**
**Kameido, 6-chome**
**Koto-ku, Tokyo (JP)**

(74) Representative : **Caro, William Egerton et al**
**J. MILLER & CO. Lincoln House 296-302 High**
**Holborn**
**London WC1V 7JH (GB)**

(54) **Switching circuit.**

(57)    A switching circuit having input terminals (1,2), switching devices (3,4) and a control circuit (6,10,11) having a control terminal (11) is formed with unidirectionally conductive devices (8,9) connected between the input terminals (1,2) and the switching devices (3,4) and also between the input terminals (1,2) and the control circuit (6,10,11) so that, when voltages (V1,V2) are applied to the input terminals (1,2) the output terminal (5) is selectively put in a fixed or a floating state according to the voltage applied to the control terminal (11).

FIG. 1

EP 0 442 688 A2

## SWITCHING CIRCUIT

This invention relates to switching circuits.

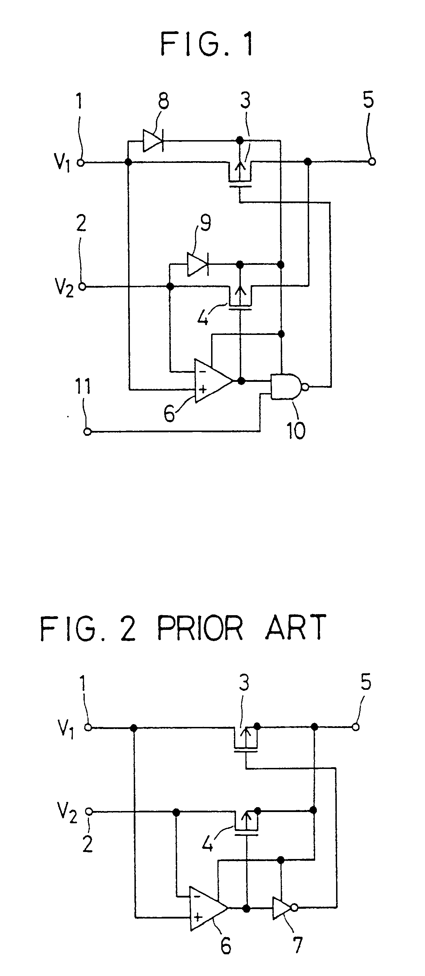

Figure 2 shows a circuit diagram of a conventional switching circuit. Input terminals 1, 2 receive different voltages V1, V2, respectively. Either of the received voltages is outputted from an output terminal 5 through corresponding switching transistors 3 and 4. The voltages V1, V2 are inputted into a comparator 6. The comparator 6 produces an output which is concurrently applied to a gate of the switching transistor 4 and to a gate of the other switching transistor 3 through an inverter 7.

When V1 > V2, the comparator 6 produces an output having a high voltage level so that the switching transistor 4 is turned OFF. On the other hand, an output of the inverter 7 is held at the low voltage level so that the other switching transistor 3 is turned ON. Consequently in this condition, the output terminal 5 provides the voltage V1. When V1 < V2, the states of the switching transistors 3, 4 are reversed so that the output terminal 5 provides the voltage V2. The comparator 6 and the inverter 7 are powered from the output terminal 5.

However, in this circuit construction, it is impossible to turn both the switching transistors OFF so as to place the output terminal 5 in a floating state. The reason for this is because a switching transistor of the MOS type is structurally accompanied by a parasitic diode having its anode coupled to either of the input terminals 1, 2 and a cathode coupled to the output terminal 5. Therefore, the output terminal 5 receives through the parasitic diode a voltage equal to the higher one of the input voltages minus a voltage drop across the parasitic diode. This voltage is sufficient to operate the comparator 6 and the inverter 7 to enable it to turn the switching transistors 3, 4 ON and OFF thereby to constitute a current path having a voltage drop smaller than the voltage drop across the parasitic diode.

For the reason described above, the output terminal 5 necessarily provides the higher one of the voltages V1 and V2, therefore a floating state cannot be realized.

The present invention seeks to provide a switching circuit responsive to an external signal to place its output terminal in the floating state.

According to one aspect of the present invention, there is provided a switching circuit having a plurality of input terminals, an output terminal, a plurality of switching devices and a control circuit having a control terminal, characterised by a plurality of unidirectionally conductive devices electrically connected between the input terminals and the switching devices, said unidirectionally conductive devices also being connected between the input terminals and the control circuit so that, in operation, when voltages are applied to the input terminals, the output terminal is selectively put in a fixed or a floating state according to the voltage applied to the control terminal.

Said control circuit may include a comparator connected to the input terminals, the output of said comparator preferably controlling a switching transistor.

Said control circuit may include a gate circuit having as inputs the control terminal and the output of said comparator so that, under particular states of the control terminal and the output of said comparator, all the switching transistors are OFF.

The invention is illustrated, merely by way of example, in the accompanying drawings, in which :-

Figure 1 is a circuit diagram of a switching circuit according to the present invention ; and

Figure 2 is a circuit diagram of the conventional switching circuit.

A specific embodiment of a monolithic switching circuit according to the present invention is described in detail with reference to Figure 1. A pair of input terminals 1, 2 are connected to an output terminal 5 through switching transistors 3, 4, respectively. The input terminals 1, 2 are connected also to a comparator 6 in a manner similar to the conventional switching circuit, shown in Figure 2. Advantageously, in the switching circuit of Figure 2, either of source and drain terminals or regions of the switching transistors 3, 4 is electrically separated from a substrate on which the switching transistors 3, 4 are formed. Furthermore, the substrate is connected to a diode 8 having its anode coupled to the input terminal 1, and is connected to another diode 9 having its anode coupled to the input terminal 2. Moreover, the substrate is used as a power supply line to the comparator 6 and to a gate circuit 10. The gate circuit 10 has one input terminal connected to a control terminal 11 receptive of a control signal and another input terminal connected to an output terminal of the comparator 6.

In operation, when voltages V1 and V2 are applied to the input terminals 1 and 2, respectively, the comparator 6 and the gate circuit 10 are placed in the operative state since the power is supplied thereto through the diodes 8, 9, respectively. At this time, the supplied electric power source voltage is equal to the higher one of the voltages V1 and V2 minus a voltage drop-developed across the corresponding diode. Then, the comparator 6 and the gate circuit 10 selectively turn ON and OFF the switching transistors 3 and 4, according to the relative magnitude difference between the voltages V1 and V2. In such operation, the control terminal 11 must be held at high level.

On the other hand, when the control terminal 11 is switched to low level, the output of the gate circuit 10 is turned to high level so that the switching transistor 3 is turned OFF. When V1 > V2 the switching transistor 4 is also turned OFF thereby to place the output terminal 5 in the floating state.

A switching circuit according to the present invention can be constructed in the form of a monolithic IC integrated with all of the components including the comparator, the gate circuit and the diodes, in the form of MOS transistors. Furthermore, the diode is preferably composed of a Shottky barrier diode having a relatively small voltage drop in the forward direction in order to improve performance of the switching circuit.

According to another aspect of the present invention, a diode is formed between each input terminal and a substrate in which the switching transistor is integrated in the form of an MOS transistor, and control circuits such as a comparator are powered through the substrate. In this construction, a pair of switching transistors can be concurrently turned OFF in response to an external control signal so as to place the output terminal in the floating state.

## Claims

1. A switching circuit having a plurality of input terminals, an output terminal, a plurality of switching devices and a control circuit having a control terminal, characterised by a plurality of unidirectionally conductive devices electrically connected between the input terminals and the switching devices, said unidirectionally conductive devices also being connected between the input terminals and the control circuit so that, in operation, when voltages are applied to the input terminals, the output terminal is selectively put in a fixed or a floating state according to the voltage applied to the control terminal.

2. A switching circuit as claimed in claim 1 characterised in that the switching devices are MOS transistors formed on a substrate and the unidirectionally conductive devices are electrically connected between the substrate and each of the input terminals.

3. A switching circuit as claimed in claim 2 characterised in that there is provided a means for supplying electric power to the control circuit through the substrate.

4. A switching circuit as claimed in any preceding claim characterised in that the unidirectionally conductive devices are diodes.

5. A switching circuit as claimed in claim 4 in which the diodes are Shottky barrier diodes.

6. In a switching circuit having a plurality of input terminals, a plurality of switching transistors of the MOS type formed on a substrate, and a control circuit ; the improvement comprising a plurality of diodes formed between the substrate and each of the input terminals ; and means for supplying electric power to the control circuit through the substrate.

# FIG. 1

# FIG. 2 PRIOR ART